# EUROPEAN PATENT SPECIFICATION

(11) **EP 3 731 218 B1**
(45) Date of publication and mention of the grant of the patent: **20.07.2022**
(21) Application number: 20160350.3
(22) Date of filing: 02.03.2020
(51) Int. Cl.: G09F 9/33

(54) **DISPLAY SCREEN MODULE AND DISPLAY SCREEN**
ANZEIGEBILDSCHIRMMODUL UND ANZEIGEBILDSCHIRM
MODULE D'ÉCRAN D'AFFICHAGE ET ÉCRAN D'AFFICHAGE

(30) Priority: 25.04.2019 CN 201920595516 U
(43) Date of publication of application: 28.10.2020
(73) Proprietor: Unilumin Group Co. Ltd., Shenzhen, Guangdong 518103 (CN)
(72) Inventor: Yang, Kuang, Shenzhen, Guangdong, 518103 (CN); Liu, Yuanxian, Shenzhen, Guangdong, 518103 (CN); Zhao, Pinglin, Shenzhen, Guangdong, 518103 (CN)
(74) Representative: Osterhoff, Utz

(56) References cited:
- CN-A- 101 789 205
- CN-U- 201 845 522
- CN-Y- 200 965 758

## Description

### TECHNICAL FIELD

The present disclosure relates to the technical field of display screens, in particular to a front maintenance display screen module and a display screen.

### BACKGROUND

In a related art, an outdoor front maintenance LED display screen module needs to be provided with a through-hole structure penetrating through front and back surfaces of the bottom case, and a rotary handle placed at the rear end of the through-hole structure. A hexagonal wrench is used to drive the rotary handle rotate through the through-hole structure from the front of the module to realize the front maintenance function. Due to the need for waterproofing, the through-hole structure needs to pass through the PCB board, and the side of the through-hole structure is a closed structure. However, when the front maintenance hole passes through a thin PCB board provided with a plurality of lamp beads close to each other, the module is very easy to be damaged during actual maintenance operations, and there will be a gap at the side wall of the front maintenance hole, causing that external moisture will enter the inside of the module through the gap.

CN201845522U discloses a front maintenance type outdoor LED display module, comprising a surface cover, a bottom seat and a PCB plate, wherein the surface cover and the PCB plate are respectively fixed on the bottom seat; a water-proof dust-proof embedding glue is filled between the surface cover and the PCB plate; at least four outdoor type quick-lock mounting devices are mounted on the bottom seat. The front maintenance type outdoor LED display module has features of effective water proof, dust proof, quick installation, convenient maintenance and greatly increased working efficiency.

CN200965758Y relates to a front protecting display screen which saves a back protecting space of the display screen, realizes the front protection and which is suitable for the display screens in a plurality of special occasions by making the display screens very thin. The utility model includes a display module, a display screen box body and a display unit, wherein a fitting hole is arranged on the fitting surface of the box body and the display unit is fixed in a fitting frame, the display unit consists of a module, the bottom shell part of the module is provided with a fitting column, the middle of the fitting column is provided with a through hole, the module is fixed on the fitting surface to form the display unit through the through hole. A riveting nut is riveted on the display unit of the box body, a bolt is welded to a column bar; the display unit is arranged on the welding bolt of the column bar through the nut; the module with a sealing pad penetrates through the through hole in the middle of the fitting column of the bottom shell of the module by the screw and is arranged on the fitting surface to form the display unit.

CN101789205A discloses a flat panel display device and a fixing mechanism for fixing a display module and a cabinet. The fixing mechanism comprises a first fixing rod, a connecting piece and a second fixing rod connected in turn, wherein the first fixing rod is positioned in a display module fixing hole; one end of the first fixing rod corresponding to the display surface of the display module is selectively clamped on the hole edge of the display module fixing hole corresponding to the display surface; the second fixing rod is positioned in a cabinet fixing hole; and one end of the second fixing rod corresponding to the back of the cabinet is selectively clamped on the hole edge of the cabinet fixing hole corresponding to the back of the cabinet. Through the fixing mechanism, the operation can be carried out on the side of the display module or on the side of the cabinet.

### SUMMARY

The main objective of the present disclosure is to provide a front maintenance display screen module with excellent waterproof performance and a display screen having the front maintenance display screen module.

In order to achieve the above objective, the present disclosure provides a display screen module according to claim 1, including: a bottom case, a PCB board provided on the bottom case, and a through-hole structure penetrating through the bottom case and the PCB board. The through-hole structure includes a step structure at one end of the through hole structure near the PCB board, and the step structure includes a convex portion and a step portion. The convex portion is configured to penetrate the PCB board, a gap is provided between the convex portion and the PCB board. The step portion includes a groove surrounding the convex portion. A side of the PCB board near the bottom case is abutted against an edge of the groove. A sealant layer is provided in the gap and the groove. The convex portion includes at least one arc structure protruded from an outer side wall of the convex portion. The PCB board includes a through hole; the convex portion is located in the through hole; the through hole includes a first notch corresponding to the arc structure, the first notch is arc-shaped; and a radius of the first notch is larger than that of the arc structure. The first notch is also provided with a second notch.

Further, a plurality of lamp beads are provided on the PCB board, and the first notch is located between two adjacent lamp beads.

Further, an outer diameter of the groove is larger than a diameter of the through hole. Further, a rounded corner is provided at a joint between the convex portion and the groove.

Further, the through-hole structure is integrally formed with the bottom case.

Further, a side of the PCB board away from the bottom case is also provided with the sealant layer.

The present disclosure further provides a display screen, including the display screen module as described above.

The beneficial effect of the present disclosure is that a sealant is provided in the gap between the PCB board and the convex portion and the groove in the step portion. Even if there are cracks, gaps, etc., at the side wall of the convex portion, external moisture does not enter the inside of the display screen module, so that the waterproof performance is excellent.

### BRIEF DESCRIPTION OF THE DRAWINGS

FIG. 1 is a front view of a front maintenance display screen module according to an embodiment of the present disclosure;
FIG. 2 is a schematic enlarged structure diagram of portion A in FIG. 1;
FIG. 3 is a cross-sectional view of the front maintenance display screen module according to an embodiment of the present disclosure;
FIG. 4 is a schematic enlarged structure diagram of portion B in FIG. 3; and
FIG. 5 is a partial cross-sectional view of the front maintenance display screen module according to an embodiment of the present disclosure.

Description of reference numerals:

| Label | Name | Label | Name |
|---|---|---|---|
| 100 | Front maintenance display screen module | 4 | Through-hole structure |
| 1 | Bottom case | 41 | Convex portion |
| 2 | PCB board | 42 | Step portion |
| 21 | First notch | 43 | Groove |
| 22 | Second notch | 44 | Arc structure |
| 3 | Lamp bead | 5 | Sealant layer |

The realization of the objective, functional characteristics, advantages of the present disclosure are further described with reference to the accompanying drawings.

### DETAILED DESCRIPTION OF THE EMBODIMENTS

In order to explain in detail the technical contents, objectives, and effects of the present disclosure, the following description will be made in conjunction with the embodiments and the accompanying drawings.

The most critical idea of the present disclosure is that a sealant is both provided in the gap between the PCB board and the convex portion and the groove in the step portion, and the waterproof performance is excellent.

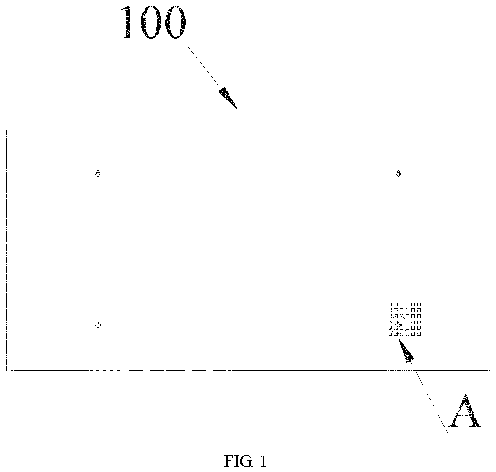

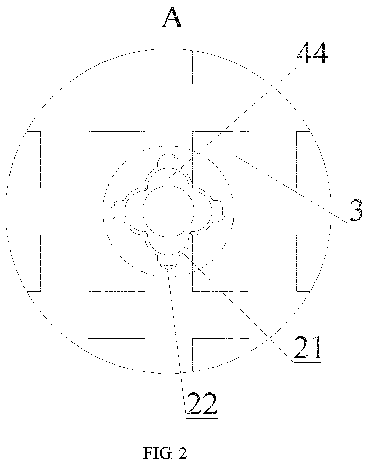

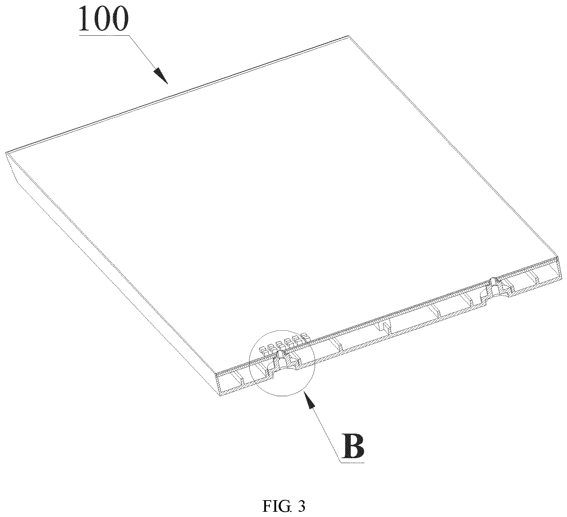

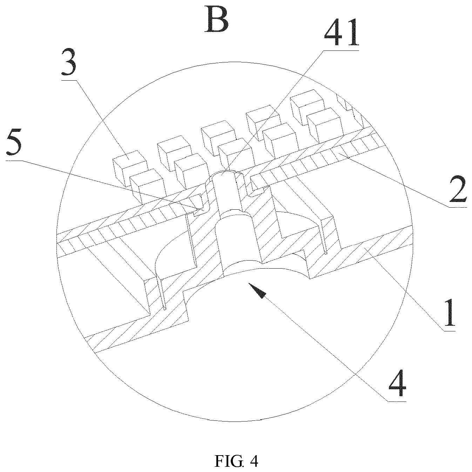

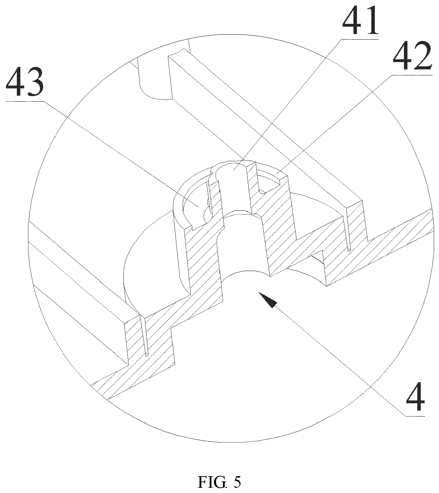

Referring to FIG. 1 to FIG. 5, the present disclosure provides a front maintenance display screen module 100, including: a bottom case 1, a PCB board 2 provided on the bottom case 1, and a through-hole structure 4 penetrating the bottom case 1 and the PCB board 2. The through-hole structure 4 includes a step structure at one end of the through hole structure near the PCB board 2, and the step structure includes a convex portion 41 and a step portion 42. The convex portion 41 is configured to penetrate the PCB board 2, a gap is provided between the convex portion 41 and the PCB board 2. The step portion 42 includes a groove 43 surrounding the convex portion 41. A side of the PCB board 2 near the bottom case 1 is abutted against an edge of the groove 43. A sealant layer 5 is provided in the gap and the groove 43.

As can be seen from the above description, the beneficial effect of the present disclosure is that a sealant is both provided in the gap between the PCB board and the convex portion and the groove in the step portion. Even if there are cracks, gaps, etc. on the side wall of the convex portion, external moisture does not enter the inside of the display screen module, and the waterproof performance is excellent.

Further, the convex portion 41 includes at least one arc structure 44 at an outer side wall of the convex portion 41 protruded from an outer side wall of the convex portion 41.

The arc structure on the convex portion can increase the thickness of the side wall of the convex portion and improve the mechanical properties.

Further, the PCB board 2 includes a through hole. The convex portion 41 is located in the through hole. The through hole includes a first notch 21 corresponding to the arc structure 44, and the first notch 21 is arc-shaped. A radius of the first notch 21 is larger than that of the arc structure 44.

Further, the first notch 21 is also provided with a second notch 22.

The second notch is provided on the first notch to facilitate the flow of the sealant liquid into the groove.

Further, a plurality of lamp bead 3 are provided on the PCB board 2, and the first notch 21 is located between two adjacent lamp beads 3.

The first notch is provided between two adjacent lamp beads. As such, it can achieve the purpose of sealing without affecting the arrangement of the lamp beads, and is suitable for the situation where the distance between the lamp beads is small.

Further, an outer diameter of the groove 43 is larger than a diameter of the through hole.

The diameter of the through hole being smaller than the outer diameter of the groove can improve the sealing effect.

Further, a rounded corner is provided at a joint between the convex portion 41 and the groove 43.

Further, the through-hole structure 4 is integrally formed with the bottom case 1.

Further, a side of the PCB board 2 away from the bottom case 1 is also provided with the sealant layer 5.

A sealant layer is also provided on the PCB board to further improve the sealing effect.

The present disclosure further provides a display screen, including the front maintenance display screen module 100 as described above.

Referring to FIG. 1 to FIG. 5, a first embodiment of the present disclosure is as follows.

The display screen includes a front maintenance display screen module 100, including: a bottom case 1, a PCB board 2 provided on the bottom case 1, and a through-hole structure 4 penetrating the bottom case 1 and the PCB board 2. In the present embodiment, the number of the through-hole structures 4 can be set as required, and the front-maintenance of the display screen module can be performed through the through-hole structure 4. The through-hole structure 4 may be integrally formed with the bottom case 1, or may be separately provided with the bottom case 1. The through-hole structure 4 includes a step structure at one end of the through hole structure near the PCB board 2, and the step structure includes a convex portion 41 and a step portion 42. The convex portion 41 is configured to penetrate the PCB board 2, a gap is provided between the convex portion 41 and the PCB board 2. In the present embodiment, the PCB board includes a through hole, and the convex portion 41 is located in the through hole. The step portion 42 includes a groove 43 surrounding the convex portion 41. A side of the PCB board 2 near the bottom case 1 is abutted against an edge of the groove 43. A sealant layer 5 is both provided in the gap and the groove 43. Optionally, a side of the PCB board 2 away from the bottom case 1 is also provided with the sealant layer 5. In order to improve the sealing effect, an outer diameter of the groove 43 is larger than a diameter of the through hole. Optionally, the convex portion 41 includes at least one arc structure 44 at an outer side wall of the convex portion 41, and the arc structure 44 is convex relative to the outer side wall of the convex portion 41. The number of arc structures 44 may be four. The through hole includes a first notch 21 corresponding to the arc structure 44, and the first notch 21 is arc-shaped. A radius of the first notch 21 is larger than that of the arc structure 44. The second notch 22 is provided on the first notch 21 to facilitate the flow of the sealant liquid into the groove 43. The shape of the second notch 22 can be set as required. In the present embodiment, a plurality of lamp bead 3 are provided on the PCB board 2, and the first notch 21 is located between two adjacent lamp beads 3.

To sum up, the front maintenance display screen module and display screen provided by the present disclosure have good waterproof performance and are suitable for situations where the distance between the lamp beads is small.

## Claims

1. A display screen module (100), comprising: a bottom case (1), a PCB board (2) provided on the bottom case (1), and a through-hole structure (4) penetrating through the bottom case (1) and the PCB board (2), wherein:
the through-hole structure (4) comprises a step structure at one end of the through hole structure (4) near the PCB board (2), and the step structure comprises a convex portion (41) and a step portion (42);
the convex portion (41) is configured to penetrate the PCB board (2), the PCB board (2) comprises a through hole, the convex portion (41) is located in the through hole, **characterised in that** a gap is
provided between the convex portion (41) and the PCB board (2);
the step portion (42) comprises a groove (43) surrounding the convex portion (41);
a side of the PCB board (2) near the bottom case (1) is abutted against an edge of the groove (43); and
a sealant layer (5) is provided in the gap and the groove (43);
the convex portion (41) comprises at least one arc structure (44) protruded from an outer side wall of the convex portion (41), the through hole comprises a first notch (21) corresponding to the arc structure, the first notch (21) is arc-shaped, a radius of the first notch (21) is larger than that of the arc structure, and the first notch (21) is also provided with a second notch (22).

2. The display screen module (100) of claim 1, wherein a plurality of lamp beads (3) are provided on the PCB board (2), and the first notch (21) is located between two adjacent lamp beads (3).

3. The display screen module (100) of claim 1, wherein an outer diameter of the groove (43) is larger than a diameter of the through hole.

4. The display screen module (100) of any one of claims 1 to 3, wherein a rounded corner is provided at a joint between the convex portion (41) and the groove (43).

5. The display screen module (100) of any one of claims 1 to 4, wherein the through-hole structure (4) is integrally formed with the bottom case (1).

6. The display screen module (100) of any one of claims 1 to 5, wherein a side of the PCB board (2) away from the bottom case (1) is also provided with the sealant layer (5).

7. A display screen, comprising the display screen module (100) of any one of claims 1 to 6.

## Patentansprüche

1. Bildschirmmodul (100), umfassend:
ein Bodengehäuse (1), eine auf dem Bodengehäuse (1) vorgesehene PCB-Platine (2) und eine Durchgangslochstruktur (4), die das Bodengehäuse (1) und die PCB-Platine (2) durchdringt,
wobei die Durchgangslochstruktur (4) eine Stufenstruktur an einem Ende der Durchgangslochstruktur (4) in der Nähe der PCB-Platine (2) umfasst und die Stufenstruktur einen konvexen Abschnitt (41) und einen Stufenabschnitt (42) umfasst;
wobei der konvexe Abschnitt (41) so konfiguriert ist, dass er die PCB-Platine (2) durchdringt, wobei die PCB- Platine (2) ein Durchgangsloch umfasst, wobei der konvexe Abschnitt (41) in dem Durchgangsloch angeordnet ist, **dadurch gekennzeichnet, dass** ein Spalt zwischen dem konvexen Abschnitt (41) und der PCB-Platine (2) vorgesehen ist;
wobei der Stufenabschnitt (42) eine den konvexen Teil (41) umgebende Rille (43) aufweist;
wobei eine Seite der PCB-Platine (2) in der Nähe des Bodengehäuses (1) gegen eine Kante der Rille (43) stößt; und
wobei in dem Spalt und in der Nut (43) eine Dichtungsschicht (5) vorgesehen ist;
wobei der konvexe Abschnitt (41) mindestens eine Bogenstruktur (44) aufweist, die von einer äußeren Seitenwand des konvexen Abschnitts (41) vorsteht, wobei das Durchgangsloch eine erste Kerbe (21) aufweist, die der Bogenstruktur entspricht, wobei die erste Kerbe (21) bogenförmig ist, wobei ein Radius der ersten Kerbe (21) größer als der der Bogenstruktur ist, und wobei die erste Kerbe (21) auch mit einer zweiten Kerbe (22) versehen ist.

2. Bildschirmmodul (100) nach Anspruch 1, wobei eine Vielzahl von Lampenkugeln (3) auf der PCB-Platine (2) vorgesehen ist und die erste Kerbe (21) zwischen zwei benachbarten Lampenkugeln (3) angeordnet ist.

3. Bildschirmmodul (100) nach Anspruch 1, wobei ein Außendurchmesser der Nut (43) größer als ein Durchmesser des Durchgangslochs ist.

4. Bildschirmmodul (100) nach einem der Ansprüche 1 bis 3, wobei eine abgerundete Ecke an einer Verbindungstelle zwischen dem konvexen Abschnitt (41) und der Nut (43) vorgesehen ist.

5. Bildschirmmodul (100) nach einem der Ansprüche 1 bis 4, wobei die Durchgangslochstruktur (4) einstückig mit dem Bodengehäuse (1) ausgebildet ist.

6. Bildschirmmodul (100) nach einem der Ansprüche 1 bis 5, wobei eine vom Bodengehäuse (1) abgewandte Seite der PCB-Platine (2) ebenfalls mit der Dichtungsschicht (5) versehen ist.

7. Bildschirm, umfassend das Bildschirmmodul (100) nach einem der Ansprüche 1 bis 6.

## Revendications

1. Un module d'écran d'affichage (100), comprenant : un boîtier inférieur (1), une carte à circuit imprimé (2) agencée sur le boîtier inférieur (1), une structure à trou traversant (4) pénétrant à travers le boîtier inférieur (1) et la carte à circuit imprimé (2), dans lequel :
la structure à trou traversant (4) comprend une structure étagée à une extrémité de la structure à trou traversant (4) proximale de la carte à circuit imprimé (2), et la structure étagée comprend une portion convexe (41) et une portion étagée (42) ;
la portion convexe (41) est configurée pour pénétrer la carte à circuit imprimé (2), la carte à circuit imprimé (2) comprend un trou traversant, la portion convexe (41) étant située dans le trou traversant, **caractérisé en ce qu'**un espace est agencé entre la portion convexe (41) et la carte à circuit imprimé (2) ;
la portion étagée (42) comprend une gorge (43) entourant la portion convexe (41) ;
un côté de la carte à circuit imprimé (2) proximal du boîtier inférieur (1) est accolé contre un bord de la gorge (43) ; et
une couche collante (5) est agencée dans l'espace et la gorge (43) ;
la portion convexe (41) comprend au moins une structure en arc (44) saillant de la paroi latérale externe de la portion convexe (41), le trou traversant comprend une première encoche (21) correspondant à la structure en arc, la première encoche (21) étant arciforme, un rayon de la première encoche (21) est plus grand que celui de la structure en arc, et la première encoche (21) est également munie d'une deuxième encoche (22).

2. Un module d'écran d'affichage (100) selon la revendication 1, dans lequel une pluralité de manchons de verres de lampe (3) est agencée sur la carte à circuit imprimé (2), et la première encoche (21) est située entre deux manchons de verres de lampe (3) adjacents.

3. Un module d'écran d'affichage (100) selon la revendication 1, dans lequel le diamètre externe de la gorge (43) est plus grand que le diamètre du trou traversant.

4. Un module d'écran d'affichage (100) selon l'une quelconque des revendication 1 à 3, dans lequel un coin arrondi est agencé à la jonction entre la portion convexe (41) et la gorge (43).

5. Un module d'écran d'affichage (100) selon l'une quelconque des revendication 1 à 4, dans lequel la structure à trou traversant (4) est intégralement formée avec le boîtier inférieur (1).

6. Un module d'écran d'affichage (100) selon l'une quelconque des revendication 1 à 5, dans lequel un côté de la carte à circuit imprimé (2) distal du boîtier inférieur (1) est également muni d'une couche collante (5).

7. Un écran d'affichage, comprenant le module d'écran d'affichage (100) de l'une quelconque des revendications 1 à 6.
